# EUROPEAN PATENT SPECIFICATION

(11) **EP 4 554 020 B1**
(45) Date of publication and mention of the grant of the patent: **22.04.2026**
(21) Application number: 24204935.1
(22) Date of filing: 07.10.2024
(51) Int. Cl.: H01S 5/00, H01S 3/23

(54) **BEAM ALIGNMENT SYSTEMS**
STRAHLAUSRICHTUNGSSYSTEME
SYSTÈMES D'ALIGNEMENT DE FAISCEAU

(30) Priority: 23.10.2023 US 202318382970
(43) Date of publication of application: 14.05.2025
(73) Proprietor: Rosemount Aerospace Inc., Burnsville, MN 55306-4898 (US)
(72) Inventor: HALAMA, Gary E., Savage, MN (US); ACOTT, Phillip, Burnsville, MN (US)
(74) Representative: Dehns

(56) References cited:
- JP-A- 2002 118 319
- JP-B2- 6 779 301
- US-A- 3 825 845
- US-B2- 10 411 435

## Description

### TECHNICAL FIELD

The present disclosure relates to beam alignment systems and methods.

### BACKGROUND

In current laser air data sensors, a mirror pair with tip/tilt alignment is used to align master laser to an optical amplifier (e.g., a preamp). A similar mirror beam splitter pair is used to align the preamp to a second optical amplifier stage. In current implementation, personnel must align the system pre-flight and during the flight as needed. Further, when shipping sensor units, misalignment can occur, even if the system was aligned prior to shipment. However, in certain circumstances, personnel may not have the technical ability or desire to align the system once the shipment is received, in particular, when a new sensor system design is being installed.

JP 2002 118319 A discloses a method for seeding an optical beam, comprising: emitting an optical beam from an energy source towards an optical amplifier along an optical axis; rotating one or more optical elements disposed with in the beam path of the optical beam between the energy source and the optical amplifier about the optical axis. It discloses in particular a system and a method for seeding an optical beam into an amplifier comprising alignment of a laser to an optical amplifier by the means of rotational elements in the form of pairs of guiding Risley prisms between the laser transmitter and the optical amplifier.

The conventional techniques have been considered satisfactory for their intended purpose. However, there is an ever present need for improved systems and methods for a more robust alignment system and for simpler alignment methods. This disclosure provides a solution for this need.

### SUMMARY

In accordance with at least one aspect of this disclosure, a method for seeding an optical beam includes, emitting an optical beam from an energy source towards an optical amplifier along an optical axis, and rotating one or more optical elements disposed with in the beam path of the optical beam between the energy source and the optical amplifier about the optical axis to a align the optical beam with a reference beam.

In embodiments, the one or more optical elements can include a first optical wedge and a second optical wedge aligned with one another along the optical axis so as to form a Risley prism configured to adjust an angle of the optical beam relative to the reference beam. In such embodiments, rotating one or more optical elements can include rotating the first optical wedge by a first amount in a first direction, and rotating the second optical wedge by a second amount in a second direction until the first optical beam is aligned with reference beam.

In embodiments, the one or more optical elements can also include, a first optical plate and a second optical plate aligned with one another along the optical axis and disposed in the beam path of the optical beam between the Risley prism and the optical amplifier configured to adjust a lateral position of the optical beam relative to the reference beam. Accordingly, in such embodiments, rotating one or more optical elements can further include rotating the one or more optical elements about the optical axis includes rotating the first plate wedge by a first amount in a first direction, and rotating the second optical plate by a second amount in a second direction

In certain embodiments, the one or more optical elements can further include a third optical wedge and a fourth optical wedge aligned with one another along the optical axis so as to form a second Risley prism disposed in the beam path of the optical beam between the Risley prism and the optical amplifier configured to adjust an angle of the optical beam relative to the reference beam. In such embodiments, rotating the one or more optical elements about the optical axis includes rotating the third optical wedge by a first amount in a first direction, and rotating the fourth optical wedge by a second amount in a second direction.

In embodiments, the method can include maintaining an alignment of the one or more optical elements within a defined plane for rotation about only the optical axis and constraining the one or more optical elements from rotation about any other axis.

In accordance with at least one aspect of this disclosure, seed beam alignment system can include, a laser transmitter configured to emit an optical beam along an optical axis, an optical amplifier configure to receive the optical beam, a first optical element pair disposed in a beam path of the optical beam between the laser transmitter and the optical amplifier, and a second optical element pair disposed in the beam path of the optical beam between the first optical element pair and the optical amplifier. The first optical element pair and the second optical element pair can be oriented relative to one another about the optical axis to align the optical beam with a predefined reference beam.

In embodiments, the first optical element pair includes a first optical wedge and a second optical wedge and the first optical element pair includes a first optical wedge and a second optical wedge and wherein the second optical wedge is oriented relative to the first optical wedge to steer the optical beam to be parallel to the reference beam.

In certain embodiments, the second optical element pair can include a first optical plate and a second optical plate and the second optical plate is oriented relative to the first optical plate to steer the optical beam to align the optical beam to be co-linear with the reference beam. In embodiments, the second optical plate can be configured to remove any deviation introduced into the optical beam from the first optical plate.

In certain embodiments, the second optical element pair can include a third optical wedge and a fourth optical wedge, wherein the fourth optical wedge is oriented relative to the third optical wedge to steer the optical beam to be parallel to the reference beam.

In embodiments, a plurality of optical element pairs can be disposed in the beam path of the optical beam, each optical element pair including a pair of optical wedges. The optical element pairs are oriented relative to one another configured to align the optical beam with the reference beam and configured to remove holes introduced into the optical beam.

In embodiments, the system can be configured to be mounted in a housing such that the first and second optical element pairs are mounted for rotation about the optical axis. In such embodiments, the first and second optical element pairs can be mounted such that the first and second op-tical element pairs are prevented from tilting about an x axis or a y axis. In embodiments, the housing can be a tubular housing.

In embodiments, the system can be configured to maintain an orientation and spacing of the first and second optical element pairs relative to one another under vibratory loads, temperature change, and/or pressure change, e.g., via a mounting structure.

In accordance with at least one aspect of this disclosure a system can include, a beam seeding alignment system. The beam seeding alignment system can include any embodiment described herein. In certain embodiments, the beam seeing alignment system can include, for example, a housing, a first optical element pair mounted to the housing, and a second optical element pair mounted to the housing.

In embodiments, the first optical element pair and the second optical element pair can be oriented relative to one another within the housing about an optical axis configured to align an optical beam emitted through the housing with a predefined reference beam to seed a master laser with an optical amplifier.

In embodiments, the first optical element pair can include a Risley prism pair, and the second optical element can include an optical plate pair. The optical plate pair can be disposed in the beam path of the optical beam between the Risley prism pair and the optical amplifier.

In certain embodiments, the housing can be a cylindrical housing, and the first and second optical element pairs can be configured to be rotated about the optical axis within the housing to align the optical beam with the reference beam. The first and second optical element pairs can be mounted in the housing for rotational adjustment only, such that the first and second optical element pairs do not tilt along any axis within the housing (e.g., the optical element pairs are constrained from rotating or tilting about any other axis).

In embodiments, the system can include a LIDAR system, where the beam seeding alignment system is optically coupled to the LIDAR system, and the optical beam is a beam of the LIDAR system. In such embodiments, the beam seeding alignment system can be configured to steer and align the optical beam of the LIDAR system relative to the optical amplifier.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, other embodiments thereof will be described in detail herein below with reference to certain figures, wherein:
Fig. 1 is a schematic perspective view of a system in accordance with this disclosure, showing an embodiment of a beam alignment system;
Fig. 2 is a schematic side view of the beam alignment system of Fig. 1 shown in a first configuration;
Fig. 3 is a schematic side view of the beam alignment system of Fig. 1 shown in a second configuration;
Fig. 4 is a schematic side view of the beam alignment system of Fig. 1 shown in a third configuration;
Fig. 5 is a schematic side view of another embodiment of a beam alignment system.

### DETAILED DESCRIPTION

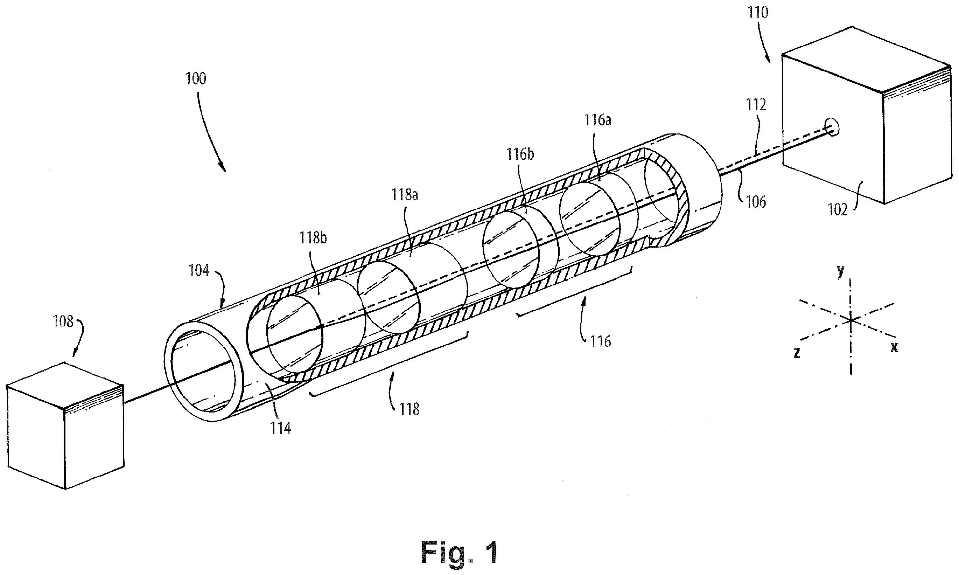

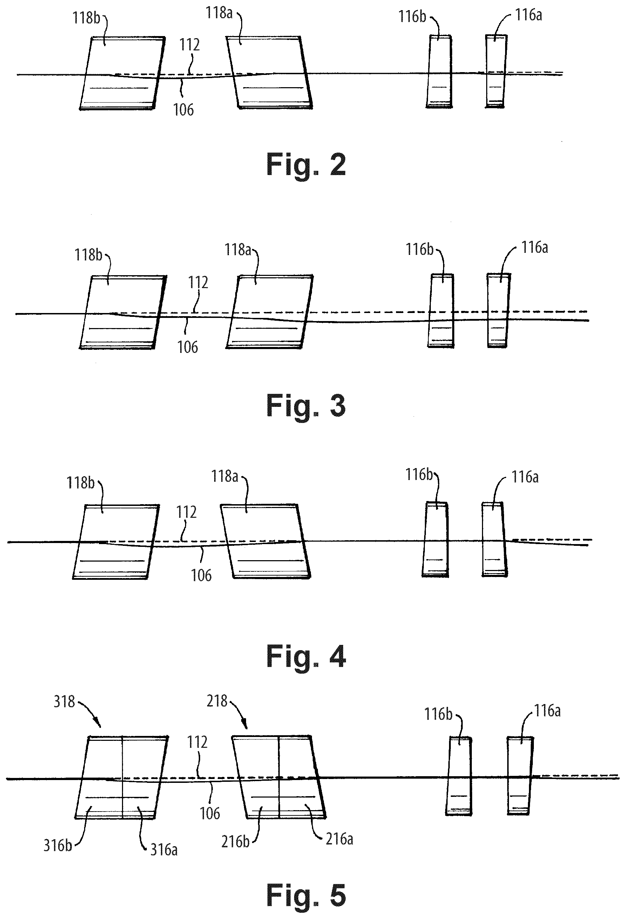

Reference will now be made to the drawings wherein like reference numerals identify similar structural features or aspects of the subject disclosure. For purposes of explanation and illustration, and not limitation, an illustrative view of an embodiment of a system in accordance with the disclosure is shown in Fig. 1 and is designated generally by reference character 100. Other embodiments and/or aspects of this disclosure are shown in Figs. 2-5.

In accordance with at least one aspect of this disclosure a system 100 can include a laser transmitter 102 and a beam seeding alignment system 104 optically coupled to the laser transmitter 102. The laser transmitter 102 is configured to transmit an optical beam 106 (e.g., a laser beam) from a master laser diode to an optical amplifier 108 disposed in the beam path. In certain embodiments, the laser transmitter 102 can be or be a part of a LIDAR system 110.

The beam seeding alignment system 104 is configured to align the optical beam 106 of the laser transmitter 102 with a reference beam 112 to properly seed the master laser diode with the optical amplifier stage 108. For example, the beam seeding alignment system 104 can include a series of optical components configured to steer and align the optical beam 106 of laser transmitter 102 relative to the reference beam 112. In the Figures, the reference beam 112 is shown in dashed lines, and the optical beam 104 emitted from the laser transmitter 102 is shown in solid lines, and moves across the page from right to left.

As shown in Fig. 1, the system 100 can include housing 114, a first optical element pair 116 mounted to the housing and a second optical element pair 118 within the housing 114. The optical element pairs 116, 118 can be mounted to or within the housing 114 to roll or tilt about an x, y, or z axis (e.g., as shown in the coordinate reference in Fig. 1). In the beam seeding alignment system 104, each of the optical elements are mounted within the housing for roll about the z axis only, and are secured to the housing in such a way that the optical elements do not tilt about the x or y axis during adjustment and should not tilt about the x or y axes during transport of the system 104. Once mounted into the housing, the optical elements are only configured for rotational movement about the z axis in order to steer the optical beam during alignment. This way, the beam seeding alignment system 104 can maintain an orientation and spacing of the first and second optical element pairs 116, 118 relative to one another, as well as the orientation and spacing of the elements within the pairs relative to tone another, under vibratory loads, temperature change, and/or pressure change. This can be crucial in harsh environments, such as aircraft, for example.

Still with reference to Fig. 1, in embodiments, the first optical element pair 116 can include a Risley prism pair 116 comprised of a first 116a and second optical wedge 116b. The second optical element pair 118 can include an optical plate pair comprised of a first 118a and second 118b optical plate. The optical plate pair 118 can be disposed in the beam path of the optical beam 106 between the Risley prism pair 116 and the optical amplifier 108, e.g., as shown. Using the axis legend in Fig. 1 to define rotational axes of the first and second optical element pairs, where the normal is defined on the x axis, extending into and out of the page, in Fig. 1, the first 116a and second 116b optical wedges of the Risely prism 116 are oriented 180° relative to one another, and the first 118a and second 118b optical plates are oriented 180° relative to one another. Fig. 1 represents a condition where no roll has been implemented and beam steering was accomplished solely using x-axis rotation. This is shown again schematically in Fig. 2 as the "reference configuration." Figs. 3-5 show beam steering using only roll, where the orientation of Fig. 1 and 2 is used as a starting orientation, for example, a "factory setting." The alignment systems and method as described herein can be used to adjust the orientation of the optical elements if they become knocked out of the original "factory setting" alignment.

In Figs. 1 and 2, the optical beam 106 is transmitted from the transmitter 102 on the right, and passes through the housing 104 to the amplifier 108 on the left of the housing 104. At the start of the hosing 104, the optical beam 106 is parallel to, but laterally offset from the reference beam 112. When the beam 106 passes through the first and second optical wedges 116a, 116b, the angle of the optical beam 106 changes, and is steered closer to the reference 112, e.g., to be parallel with the reference beam 112, if it was not already. For example, each wedge 116a and 116b cause the beam angle to change in such a manner that the combination of the angle changes result in the beam 106 exitting the pair 116 parallel to the reference beam 112. The lateral offset of the beam 106 at the input of the pair 116 can be selected such that at the output of 116, the beam 106 lies on top of the reference 112. I

n Fig. 1, at the output of the second optical wedge 116b, the optical beam 104 is co-linear with the reference beam 112. The first and second optical plates 118a, 118b are then configured to steer the lateral position of the beam 106, for example, as best seen in Fig. 2, the first optical plate 118a introduces a lateral offset and the second optical plate 118b removes the offset. Thus, at the output of the second optical plate 118b, the optical beam 106 maintains its co-linearity with the reference beam 112.

Now, with reference to Fig. 3, the first and second optical wedges 116a, 116b of the Risley prism 116 remain in the same orientation as Fig. 1 and 2, but the first optical plate 118a has been rolled 180° about the optical axis. In this example, the optical beam 106 has a greater lateral offset at the output of the laser transmitter 102 than in Fig. 1 and 2, and thus will require a greater lateral adjustment by the optical plates 118. The beam 106 first passes through the Risley prism 116, which should not cause any angular shift on the beam 106 since the beam 106 is already parallel to the reference 112. The first and second optical plates 118a, 118b are then able to take the optical beam 106 and shift it upwards to be co-linear with the reference 112. The orientation shown in Fig. 3 allows for a maximum lateral shift adjustment of the optical beam 106.

Now referring to Fig. 4, the first and second optical plates 118a, 118b are in the same orientation as Fig. 1 and 2, but the first optical wedge 116a of the Risley prism 116 has been rolled 180° about the optical axis. Here, the optical beam exits the laser transmitter 102 at an angle that is not parallel to the reference beam 112. Here, the optical beam 106 will require a greater angular adjustment by the optical wedges 116. The beam first passes through the first optical wedge 116a of the Risley prism 116, which changes the angle of the beam 106 to steer the optical beam 106 to parallel, or near parallel to the reference beam 112. The second optical wedge 116b of the Risley prism 116 makes any remaining adjustment to the angle relative to the reference 112 to ensure the beam 106 exits the Risley prism 116 parallel to the reference beam 112. The first and second optical plates 118, 118b are then able to steer the optical beam 106 and shift it upwards to be co-linear with the reference 112, if such adjustment is needed. However, if the beam 106 exits the Risley prism 106 co-linear with the refence, any lateral shift in the beam due to the first optical plate 118a will be removed with the second optical plate 118b. The orientation shown in Fig. 4 allows for a maximum angular adjustment in the optical beam 106.

With reference to Fig. 5, the first and second optical plates 118a, 118b can be replaced with a second 218 and third 318 Rislely prism pair. As shown, the respective wedges of the second 216a, 216b and third 316a, 316b Risley prism pairs can abut one another to effectively form optical plates 218, 318 similar to those described above. This is seen in Fig. 5 where the optical beam 106 follows the same path as the optical beam in Figs. 1 and 2, since the second 218 and third 318 Risley prisms are oriented in the same manner as the optical plates 118a, 118b. However it is also contemplated that the respective wedges 216a, 216b and/or 316a, 316b can be separated as shown with respect to the first Risley prism 116. The roll of each optical wedge 216a, 216b, 316a, 316b of the second and third Risley prisms 218, 318 can be adjusted in a similar manner to that described above to achieve the designed angular shift in the optical beam 106 relative to the reference beam 112. Any suitable number of Risley prism pairs can be added in the beam path, and, due to the random tolerance of the manufacturing process, as more Risley prisms are added, the overall blind spot of angle space and lateral displacement space can be reduced. Therefore replacing the optical plates with Risley prisms as shown in Fig. 5, provides improved alignment capabilities.

In accordance with at least one aspect of this disclosure, a method for seeding an optical beam, e.g., using the system 104 described herein above, includes, emitting an optical beam (e.g., beam 106) from an energy source (e.g., laser transmitter 102) towards, at least, an optical amplifier (e.g., optical amplifier 108) along an optical axis, and rotating one or more optical elements (e.g., elements 116, 118) disposed within the beam path about the optical axis to a align the optical beam with a reference beam (e.g., reference 112).

In embodiments, the one or more optical elements can include a first optical wedge and a second optical wedge (e.g., wedges 116a, 116b) aligned with one another along the optical axis so as to form a Risley prism (e.g., prism 116). In such embodiments, rotating the one or more optical elements can include rotating the first optical wedge by a first amount in a first direction, and rotating the second optical wedge by a second amount in a second direction (e.g., the same as or opposite the first direction) until the optical beam is at least parallel with reference beam.

As shown in Figs. 1-4 the one or more optical elements can also include a first optical plate and a second optical plate (e.g., plates 118, 118b) aligned with one another along the optical axis and disposed in the beam path between the Risley prism and the optical amplifier configured to adjust a lateral position of the optical beam relative to the reference beam. Accordingly, in such embodiments, rotating one or more optical elements can further include rotating the rotating the first plate wedge by a first amount in a first direction, and rotating the second optical plate by a second amount in a second direction (e.g., the same as or opposite the first direction).

Depending on the starting position of the optical beam relative to the reference beam, the first and/or second amount could be 0. As used herein, the first and second amount is measured as a number of degrees of rotation about the optical axis between - 180° and 180°, and the first and second direction refers to a direction of rotation, e.g., positive or negative, about the optical axis. This scheme applies to any of the optical elements described with respect to Figs. 1-5 with reference to the alignment method. In the examples presented herein, the roll angles that are shown for illustration purposes keep the beam 106 in the Y-Z plane. In general, however, any roll angle, (±180 degrees) for any component can be chosen to achieve any point within the maximum linear offset radius and inside the cone of the maximum deviation angle, for example as shown in Figs. 3 and 4, assuming identical glass plates and identical prism wedges are used.

In certain embodiments, such as shown in Fig. 5 for example, the one or more optical elements can further include a third optical wedge and a fourth optical wedge (e.g., wedges 216a, 216b) aligned with one another along the optical axis so as to form a second Risley prism (e.g., second prism 218). A fifth optical wedge and a sixth optical wedge (e.g., wedges 316a, 316b) can be included in the optical path aligned with one another along the optical axis so as to form a third Risley prism (e.g., third prism 318). The second and third Risley prisms are disposed in the beam path of the optical beam between the first Risley prism and the optical amplifier. Here, the method can further include, rotating the third optical wedge by a first amount in a first direction, and rotating the fourth optical wedge by a second amount in a second direction. The same can be true for the fifth and sixth optical wedges. In certain embodiments, however, rotating the second and third Risley prisms can include rotating the prisms as a pair, such that the third and fourth optical wedges are together rotated by a first amount and in a first direction, while the fifth and sixth optical wedges are together rotated in a second direction by a second amount.

The method can include maintaining an alignment of the one or more optical elements within a defined plane for rotation about only the optical axis and constraining the one or more optical elements from rotation about any other axis. For example, the optical elements can be mounted in the housing (e.g., a cylindrical or tubular housing as shown) via a cylindrical disk fixture.

Embodiments of the alignment system disclosed herein include a Risley Prism pair and two glass plates to be used as the alignment optics for a seed beam (e.g., from a master laser) to an optical amplifier. The prisms and glass plates can be locked to maintain alignment of a master laser diode to optical amplifier stage. In certain embodiments, the size of the master laser diode facet is on the order of a few microns and the optical amplifier has a facet that is a few to tens of microns. In embodiments, the alignment system and method can also be used to align a beam from the output on the optical amplifier to another optical amplifier.

As discussed above, because the components used roll about the z-axis, the locking/clamping method is used for adjustment in the z-axis only. The mechanical housing will thus be less susceptible to tilt about the x- and y- axes because there are no adjustment means provided for such rotations. Mounting the elements in the housing in such a manner can include mounting the components in a cylindrical disk fixture and then secured in a tube. This, along with the Risley prism, makes the alignment system described herein less susceptible to aircraft vibration than a reflection from a mirror or beam splitter, for example, which are typically used for beam alignment by tilting along the x- and y-axes. Analysis of the optical path deviation due to roll, pitch, and yaw of a prism in described embodiments, versus a mirror shows an order a magnitude less deviation is the optical path. The Risley prism also has low susceptibility to atmospheric pressure and environmental temperature changes, which provides alignment robustness to the described systems and method.

In embodiments, to optimize the mode matching between a seed laser and an optical amplifier, the beam size, shape, alignment and polarization properties should be well matched. For a Risley prism with a small angle of wedge (~ a few degrees), the image shape changes are small and do not have significant effect on beam size matching (e.g., from the seed to the amplifier). The Risley prisms and glass plates as described herein may have an effect on the polarization, but the degree of polarization will depend on the angle of indigence to the surfaces. For small angles, the transmitted fields have a negligible effect on the polarization.

As shown in Fig. 5, embodiments include a configuration where the angled glass plates are replacement by a Risley prism pairs. As the wedge angle varies (e.g., due to manufacturing tolerance limitation), the alignment system will be better able to cover the blind spot of angle space and lateral displacement space. As Risley prism pairs are added to the system, the random tolerance of the manufacturing process is used to reduce the blind spot, and the glass plates may no longer be needed. As shown in Fig. 5, a Risley Prism pair can have an equivalent function to the angle glass plate in certain configurations.

Conventionally, a pair of tip-tilt mirrors are used for laser beam alignment. Tip-tilt mirror usually require a spring and a locking mechanism, which make them susceptible to vibration and thermal misalignment. Embodiments of the beam alignment system and method described herein replace the tip-tilt mirrors with Risley prism pairs and plates in beam seeding. By holding the optics in a cylinder along the optical axis (e.g., mounting the elements within the housing as described herein) and rotating the optical pieces removes the need to tip the optical elements. Because the parts fit into an easily machined cylinder, the parts can be pre-aligned by design and manufacturing costs can be reduced due to the simplified nature of the housing.

The articles "a", "an", and "the" as used herein and in the appended claims are used herein to refer to one or to more than one (i.e., to at least one) of the grammatical object of the article unless the context clearly indicates otherwise. By way of example, "an element" means one element or more than one element.

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of' or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of"

Any suitable combination(s) of any disclosed embodiments and/or any suitable portion(s) thereof are contemplated herein as appreciated by those having ordinary skill in the art in view of this disclosure.

The embodiments of the present disclosure, as described above and shown in the drawings, provide for improvement in the art to which they pertain. While the apparatus and methods of the subject disclosure have been shown and described, those skilled in the art will readily appreciate that changes and/or modifications may be made thereto without departing from the scope of the subject disclosure.

## Claims

1. A method for seeding an optical beam (106), comprising:
emitting an optical beam (106) from an energy source (102) towards an optical amplifier along an optical axis;
rotating one or more optical elements disposed within the beam path of the optical beam (106) between the energy source (102) and the optical amplifier about the optical axis to align the optical beam (106) with a reference beam.

2. The method of claim 1, wherein the one or more optical elements includes a first optical wedge and a second optical wedge aligned with one another along the optical axis so as to form a Risley prism configured to adjust an angle of the optical beam (106) relative to the reference beam,
wherein rotating the one or more optical elements about the optical axis includes rotating the first optical wedge by a first amount in a first direction, and rotating the second optical wedge by a second amount in a second direction until the optical beam (106) is parallel with reference beam.

3. The method of claim 2, wherein the one or more optical elements further includes a first optical plate and a second optical plate aligned with one another along the optical axis disposed in the beam path of the optical beam (106) between the Risley prism and the optical amplifier configured to adjust a lateral position of the optical beam (106) relative to the reference beam,
wherein rotating the one or more optical elements about the optical axis includes rotating the first optical plate by a first amount in a first direction, and rotating the second optical plate by a second amount in a second direction until the optical beam (106) is co-linear with reference beam.

4. The method of claim 2, wherein the one or more optical elements further includes a third optical wedge and a fourth optical wedge aligned with one another along the optical axis so as to form a second Risley prism disposed in the beam path of the optical beam (106) between the Risley prism and the optical amplifier configured to adjust an angle of the optical beam (106) relative to the reference beam,
wherein rotating the one or more optical elements about the optical axis includes rotating the third optical wedge by a first amount in a first direction, and rotating the fourth optical wedge by a second amount in a second direction until the optical beam (106) is parallel with reference beam.

5. The method of any preceding claim, further comprising, maintaining an alignment of the one or more optical elements within a defined plane for rotation about only the optical axis; and
constraining the one or more optical elements from rotation about any other axis.

6. A seed beam alignment system configured to perform the method of claim 1, comprising:
a laser transmitter configured to emit an optical beam (106) along an optical axis;
an optical amplifier configured to receive the optical beam (106);
a first optical element pair disposed in a beam path of the optical beam (106) between the laser transmitter and the optical amplifier; and
a second optical element pair disposed in the beam path of the optical beam (106) between the first optical element pair and the optical amplifier,
means for emitting a predefined reference beam,
wherein the first optical element pair and the second optical element pair are oriented relative to one another about the optical axis to align the optical beam (106) with the predefined reference beam.

7. The system of claim 6, wherein the first optical element pair includes a first optical wedge and a second optical wedge and wherein the first optical wedge is oriented relative to the second optical wedge to steer the optical beam (106) to be parallel to the reference beam.

8. The system of claim 7, wherein the second optical element pair includes a first optical plate and a second optical plate wherein the second optical plate is oriented relative to the first optical plate to steer the optical beam (106) to align the optical beam (106) to be co-linear with the reference beam.

9. The system of claim 7, wherein the second optical element pair includes a third optical wedge and a fourth optical wedge, wherein the fourth optical wedge is oriented relative to the third optical wedge to steer the optical beam (106) to be parallel to the reference beam, and optionally further comprising, a plurality of optical element pairs disposed in the beam path of the optical beam (106), each optical element pair including a pair of optical wedges, wherein the optical element pairs are oriented relative to one another configured to align the optical beam (106) with the reference beam and configured to remove holes introduced into the optical beam (106).

10. The system of claim 6, wherein the system is configured to be mounted in a housing such that the first and second optical element pairs are mounted for rotation about the optical axis, wherein the first and second optical element pairs are mounted such that the first and second optical element pairs are prevented from tilting about an x axis or a y axis.

11. The system of claim 10, wherein the housing is a cylindrical housing.

12. The system of claim 10, wherein the system is configured to maintain an orientation and spacing of the first and second optical element pairs relative to one another under vibratory loads, temperature change, and/or pressure change.

13. A system, comprising
the beam seeding alignment system of claim 6, comprising:
a housing;
the first optical element pair mounted to the housing; and
the second optical element pair mounted to the housing,
wherein the first optical element pair and the second optical element pair are oriented relative to one another within the housing about the optical axis configured to align the optical beam (106) emitted through the housing with a predefined reference beam to seed a master laser with the optical amplifier.

14. The system of claim 13, wherein the first optical element pair includes a Risley prism pair, and wherein the second optical element includes an optical plate pair, wherein the optical plate pair is disposed in the beam path of the optical beam (106) between the Risley prism pair and the optical amplifier.

15. The system of claim 13 wherein the housing is a cylindrical housing, wherein the first and second optical element pairs are configured to be rotated about the optical axis within the housing to align the optical beam (106) with the reference beam, and optionally wherein the first and second optical element pairs are mounted in the housing for rotational adjustment only, or further comprising a LIDAR system, wherein the beam seeding alignment system is optically coupled to the LIDAR system, wherein the optical beam (106) is a beam of the LIDAR system, wherein the beam seeding alignment system is configured to steer and align the optical beam (106) of the LIDAR system relative to the optical amplifier.

## Patentansprüche

1. Verfahren zum Einspeisen eines optischen Strahls (106), umfassend:
Emittieren eines optischen Strahls (106) von einer Energiequelle (102) entlang einer optischen Achse in Richtung eines optischen Verstärkers;
Drehen eines oder mehrerer optischer Elemente, die im Strahlengang des optischen Strahls (106) zwischen der Energiequelle (102) und dem optischen Verstärker angeordnet sind, um die optische Achse, um den optischen Strahl (106) mit einem Referenzstrahl auszurichten.

2. Verfahren nach Anspruch 1, wobei das eine oder die mehreren optischen Elemente einen ersten optischen Keil und einen zweiten optischen Keil beinhaltet, die entlang der optischen Achse miteinander ausgerichtet sind, um ein Risley-Prisma zu bilden, das ausgelegt ist, einen Winkel des optischen Strahls (106) relativ zum Referenzstrahl anzupassen,
wobei das Drehen des einen oder der mehreren optischen Elemente um die optische Achse das Drehen des ersten optischen Keils um einen ersten Betrag in eine erste Richtung und das Drehen des zweiten optischen Keils um einen zweiten Betrag in eine zweite Richtung beinhaltet, bis der optische Strahl (106) parallel zum Referenzstrahl ist.

3. Verfahren nach Anspruch 2, wobei das eine oder die mehreren optischen Elemente ferner eine erste optische Platte und eine zweite optische Platte beinhaltet, die entlang der optischen Achse miteinander ausgerichtet sind und im Strahlengang des optischen Strahls (106) zwischen dem Risley-Prisma und dem optischen Verstärker angeordnet sind, ausgelegt zum Anpassen einer lateralen Position des optischen Strahls (106) relativ zum Referenzstrahl,
wobei das Drehen des einen oder der mehreren optischen Elemente um die optische Achse das Drehen der ersten optischen Platte um einen ersten Betrag in eine erste Richtung und das Drehen der zweiten optischen Platte um einen zweiten Betrag in eine zweite Richtung beinhaltet, bis der optische Strahl (106) kollinear mit dem Referenzstrahl ist.

4. Verfahren nach Anspruch 2, wobei das eine oder die mehreren optischen Elemente ferner einen dritten optischen Keil und einen vierten optischen Keil beinhaltet, die entlang der optischen Achse miteinander ausgerichtet sind, um ein zweites Risley-Prisma zu bilden, das im Strahlengang des optischen Strahls (106) zwischen dem Risley-Prisma und dem optischen Verstärker angeordnet ist, ausgelegt zum Anpassen eines Winkels des optischen Strahls (106) relativ zum Referenzstrahl,
wobei das Drehen des einen oder der mehreren optischen Elemente um die optische Achse das Drehen des dritten optischen Keils um einen ersten Betrag in eine erste Richtung und das Drehen des vierten optischen Keils um einen zweiten Betrag in eine zweite Richtung beinhaltet, bis der optische Strahl (106) parallel zum Referenzstrahl ist.

5. Verfahren nach einem der vorhergehenden Ansprüche, ferner umfassend das Aufrechterhalten einer Ausrichtung des einen oder der mehreren optischen Elemente innerhalb einer definierten Ebene zur Drehung nur um die optische Achse; und
Einschränken des einen oder der mehreren optischen Elemente von einer Drehung um jede andere Achse.

6. Seedstrahl-Ausrichtungssystem, ausgelegt zum Durchführen des Verfahrens nach Anspruch 1, umfassend:
einen Lasersender, ausgelegt zum Emittieren eines optischen Strahls (106) entlang einer optischen Achse;
einen optischen Verstärker, ausgelegt zum Empfangen des optischen Strahls (106);
ein erstes optisches Elementpaar, das im Strahlengang des optischen Strahls (106) zwischen dem Lasersender und dem optischen Verstärker angeordnet ist; und
ein zweites optisches Elementpaar, das im Strahlengang des optischen Strahls (106) zwischen dem ersten optischen Elementpaar und dem optischen Verstärker angeordnet ist,
Mittel zum Emittieren eines vordefinierten Referenzstrahls,
wobei das erste optische Elementpaar und das zweite optische Elementpaar relativ zueinander um die optische Achse orientiert sind, um den optischen Strahl (106) mit dem vordefinierten Referenzstrahl auszurichten.

7. System nach Anspruch 6, wobei das erste optische Elementpaar einen ersten optischen Keil und einen zweiten optischen Keil beinhaltet und wobei der erste optische Keil relativ zum zweiten optischen Keil orientiert ist, um den optischen Strahl (106) so zu lenken, dass er parallel zum Referenzstrahl ist.

8. System nach Anspruch 7, wobei das zweite optische Elementpaar eine erste optische Platte und eine zweite optische Platte beinhaltet, wobei die zweite optische Platte relativ zur ersten optischen Platte orientiert ist, um den optischen Strahl (106) zu lenken, um den optischen Strahl (106) kollinear mit dem Referenzstrahl auszurichten.

9. System nach Anspruch 7, wobei das zweite optische Elementpaar einen dritten optischen Keil und einen vierten optischen Keil beinhaltet, wobei der vierte optische Keil relativ zum dritten optischen Keil orientiert ist, um den optischen Strahl (106) so zu lenken, dass er parallel zum Referenzstrahl ist, und optional ferner umfassend eine Vielzahl von optischen Elementpaaren, die im Strahlengang des optischen Strahls (106) angeordnet sind, wobei jedes optische Elementpaar ein Paar optischer Keile beinhaltet, wobei die optischen Elementpaare relativ zueinander orientiert sind, ausgelegt zum Ausrichten des optischen Strahls (106) mit dem Referenzstrahl und ausgelegt zum Entfernen von Löchern, die in den optischen Strahl (106) eingebracht wurden.

10. System nach Anspruch 6, wobei das System ausgelegt ist, in einem Gehäuse montiert zu werden, sodass das erste und das zweite optische Elementpaar zur Drehung um die optische Achse montiert sind, wobei das erste und das zweite optische Elementpaar so montiert sind, dass das erste und das zweite optische Elementpaar daran gehindert sind, um eine x-Achse oder eine y-Achse zu kippen.

11. System nach Anspruch 10, wobei das Gehäuse ein zylindrisches Gehäuse ist.

12. System nach Anspruch 10, wobei das System ausgelegt ist, eine Orientierung und einen Abstand des ersten und des zweiten optischen Elementpaars relativ zueinander unter Schwingungsbelastungen, Temperaturänderungen und/oder Druckänderungen aufrechtzuerhalten.

13. System, umfassend
das Strahl-Einspeise-Ausrichtungssystem nach Anspruch 6, umfassend:
ein Gehäuse;
das erste optische Elementpaar, am Gehäuse montiert; und
das zweite optische Elementpaar, am Gehäuse montiert,
wobei das erste optische Elementpaar und das zweite optische Elementpaar relativ zueinander innerhalb des Gehäuses um die optische Achse orientiert sind, ausgelegt zum Ausrichten des durch das Gehäuse emittierten optischen Strahls (106) mit einem vordefinierten Referenzstrahl, um einen Masterlaser mit dem optischen Verstärker einzuspeisen.

14. System nach Anspruch 13, wobei das erste optische Elementpaar ein Risley-Prismenpaar beinhaltet und wobei das zweite optische Element ein optisches Plattenpaar beinhaltet, wobei das optische Plattenpaar im Strahlengang des optischen Strahls (106) zwischen dem Risley-Prismenpaar und dem optischen Verstärker angeordnet ist.

15. System nach Anspruch 13, wobei das Gehäuse ein zylindrisches Gehäuse ist, wobei das erste und das zweite optische Elementpaar ausgelegt sind, um die optische Achse innerhalb des Gehäuses gedreht zu werden, um den optischen Strahl (106) mit dem Referenzstrahl auszurichten, und optional wobei das erste und das zweite optische Elementpaar im Gehäuse nur zur Drehungsanpassung montiert sind, oder ferner umfassend ein LIDAR-System (LIDAR - Light Detection and Ranging), wobei das Seedstrahl-Ausrichtungssystem optisch mit dem LIDAR-System gekoppelt ist, wobei der optische Strahl (106) ein Strahl des LIDAR-Systems ist, wobei das Seedstrahl-Ausrichtungssystem ausgelegt ist, den optischen Strahl (106) des LIDAR-Systems relativ zum optischen Verstärker zu lenken und auszurichten.

## Revendications

1. Procédé d'amorçage d'un faisceau optique (106), comprenant :
l'émission d'un faisceau optique (106) d'une source d'énergie (102) vers un amplificateur optique le long d'un axe optique ;
la rotation d'un ou plusieurs éléments optiques disposés dans le trajet de faisceau du faisceau optique (106) entre la source d'énergie (102) et l'amplificateur optique autour de l'axe optique pour aligner le faisceau optique (106) avec un faisceau de référence.

2. Procédé selon la revendication 1, dans lequel les un ou plusieurs éléments optiques comportent un premier coin optique et un deuxième coin optique alignés l'un avec l'autre le long de l'axe optique de manière à former un prisme de Risley configuré pour ajuster un angle du faisceau optique (106) par rapport au faisceau de référence,
dans lequel la rotation des un ou plusieurs éléments optiques autour de l'axe optique comporte la rotation du premier coin optique d'une première quantité dans une première direction, et la rotation du deuxième coin optique d'une seconde quantité dans une seconde direction jusqu'à ce que le faisceau optique (106) soit parallèle au faisceau de référence.

3. Procédé selon la revendication 2, dans lequel les un ou plusieurs éléments optiques comportent en outre une première plaque optique et une seconde plaque optique alignées l'une avec l'autre le long de l'axe optique, disposées dans le trajet de faisceau du faisceau optique (106) entre le prisme de Risley et l'amplificateur optique, configurées pour ajuster une position latérale du faisceau optique (106) par rapport au faisceau de référence,
dans lequel la rotation des un ou plusieurs éléments optiques autour de l'axe optique comporte la rotation de la première plaque optique d'une première quantité dans une première direction, et la rotation de la seconde plaque optique d'une seconde quantité dans une seconde direction jusqu'à ce que le faisceau optique (106) soit colinéaire avec un faisceau de référence.

4. Procédé selon la revendication 2, dans lequel les un ou plusieurs éléments optiques comportent en outre un troisième coin optique et un quatrième coin optique alignés l'un avec l'autre le long de l'axe optique de manière à former un second prisme de Risley disposé sur le trajet de faisceau du faisceau optique (106) entre le prisme de Risley et l'amplificateur optique configuré pour ajuster un angle du faisceau optique (106) par rapport au faisceau de référence,
dans lequel la rotation des un ou plusieurs éléments optiques autour de l'axe optique comporte la rotation du troisième coin optique d'une première quantité dans une première direction, et la rotation du quatrième coin optique d'une seconde quantité dans une seconde direction jusqu'à ce que le faisceau optique (106) soit parallèle au faisceau de référence.

5. Procédé selon une quelconque revendication précédente, comprenant en outre le maintien d'un alignement des un ou plusieurs éléments optiques dans un plan défini pour une rotation uniquement autour de l'axe optique ; et
le fait d'empêcher les un ou plusieurs éléments optiques de tourner autour de tout autre axe.

6. Système d'alignement de faisceau d'amorçage configuré pour réaliser le procédé selon la revendication 1, comprenant :
un émetteur laser configuré pour émettre un faisceau optique (106) le long d'un axe optique ;
un amplificateur optique configuré pour recevoir le faisceau optique (106) ;
une première paire d'éléments optiques disposée dans un trajet de faisceau du faisceau optique (106) entre l'émetteur laser et l'amplificateur optique ; et
une seconde paire d'éléments optiques disposée dans le trajet de faisceau du faisceau optique (106) entre la première paire d'éléments optiques et l'amplificateur optique,
un moyen d'émission d'un faisceau de référence prédéfini,
dans lequel la première paire d'éléments optiques et la seconde paire d'éléments optiques sont orientées l'une par rapport à l'autre autour de l'axe optique pour aligner le faisceau optique (106) avec le faisceau de référence prédéfini.

7. Système selon la revendication 6, dans lequel la première paire d'éléments optiques comporte un premier coin optique et un deuxième coin optique, et dans lequel le premier coin optique est orienté par rapport au deuxième coin optique pour diriger le faisceau optique (106) afin qu'il soit parallèle au faisceau de référence.

8. Système selon la revendication 7, dans lequel la seconde paire d'éléments optiques comporte une première plaque optique et une seconde plaque optique, dans lequel la seconde plaque optique est orientée par rapport à la première plaque optique pour diriger le faisceau optique (106) afin d'aligner le faisceau optique (106) pour qu'il soit colinéaire avec le faisceau de référence.

9. Système selon la revendication 7, dans lequel la seconde paire d'éléments optiques comporte un troisième coin optique et un quatrième coin optique, dans lequel le quatrième coin optique est orienté par rapport au troisième coin optique pour diriger le faisceau optique (106) afin qu'il soit parallèle au faisceau de référence, et comprenant, en outre, éventuellement une pluralité de paires d'éléments optiques disposées dans le trajet de faisceau du faisceau optique (106), chaque paire d'éléments optiques comportant une paire de coins optiques, dans lequel les paires d'éléments optiques sont orientées les unes par rapport aux autres, configurées de manière à aligner le faisceau optique (106) avec le faisceau de référence et configurées pour supprimer des trous introduits dans le faisceau optique (106).

10. Système selon la revendication 6, dans lequel le système est configuré pour être monté dans un boîtier de sorte que les première et seconde paires d'éléments optiques soient montées pour tourner autour de l'axe optique, dans lequel les première et seconde paires d'éléments optiques sont montées de sorte que les première et seconde paires d'éléments optiques soient empêchées de basculer autour d'un axe x ou d'un axe y.

11. Système selon la revendication 10, dans lequel le boîtier est un boîtier cylindrique.

12. Système selon la revendication 10, dans lequel le système est configuré pour maintenir une orientation et un espacement des première et seconde paires d'éléments optiques l'une par rapport à l'autre sous des charges vibratoires, un changement de température et/ou un changement de pression.

13. Système, comprenant
le système d'alignement par amorçage de faisceau selon la revendication 6, comprenant :
un boîtier ;
la première paire d'éléments optiques montée sur le boîtier ; et
la seconde paire d'éléments optiques montée sur le boîtier,
dans lequel la première paire d'éléments optiques et la seconde paire d'éléments optiques sont orientées l'une par rapport à l'autre à l'intérieur du boîtier autour de l'axe optique, configurées pour aligner le faisceau optique (106) émis à travers le boîtier avec un faisceau de référence prédéfini pour amorcer un laser maître avec l'amplificateur optique.

14. Système selon la revendication 13, dans lequel la première paire d'éléments optiques comporte une paire de prismes de Risley, et dans lequel le second élément optique comporte une paire de plaques optiques, dans lequel la paire de plaques optiques est disposée dans le trajet de faisceau du faisceau optique (106) entre la paire de prismes de Risley et l'amplificateur optique.

15. Système selon la revendication 13, dans lequel le boîtier est un boîtier cylindrique, dans lequel les première et seconde paires d'éléments optiques sont configurées pour être tournées autour de l'axe optique à l'intérieur du boîtier afin d'aligner le faisceau optique (106) avec le faisceau de référence, et dans lequel éventuellement les première et seconde paires d'éléments optiques sont montées dans le boîtier pour un ajustement rotatif uniquement, ou comprenant en outre un système LIDAR, dans lequel le système d'alignement par amorçage de faisceau est couplé optiquement au système LIDAR, dans lequel le faisceau optique (106) est un faisceau du système LIDAR, dans lequel le système d'alignement par amorçage de faisceau est configuré pour diriger et aligner le faisceau optique (106) du système LIDAR par rapport à l'amplificateur optique.
